Europäisches Patentamt

European Patent Office

Office européen des brevets

(19)

(11) **EP 1 235 270 A2**

(12) **EUROPÄISCHE PATENTANMELDUNG**

(43) Veröffentlichungstag:
  **28.08.2002 Patentblatt 2002/35**

(51) Int Cl.7: **H01L 21/66**

(21) Anmeldenummer: **02003676.0**

(22) Anmeldetag: **18.02.2002**

(84) Benannte Vertragsstaaten:
  **AT BE CH CY DE DK ES FI FR GB GR IE IT LI LU
  MC NL PT SE TR**
  Benannte Erstreckungsstaaten:
  **AL LT LV MK RO SI**

(30) Priorität: **23.02.2001 DE 10108928**

(71) Anmelder: **Infineon Technologies AG**
  **81669 München (DE)**

(72) Erfinder:
  • **Pöppel, Gerhard, Dr.**
    **93049 Regensburg (DE)**
  • **Wachtmeister, Frank**
    **93057 Regensburg (DE)**

(74) Vertreter: **Kindermann, Peter, Dipl.-Ing.**
  **Karl-Böhm-Strasse 1**
  **85598 Baldham (DE)**

(54) **Verfahren zum Ermitteln von Fertigungs-und/oder Prozessierungsschwächen, Verfahren zum Ermitteln von Maschinentrends sowie zugehörige Komponenten**

(57) Erläutert wird unter anderem ein Verfahren, bei dem ein Halbzeug (12) eine Vielzahl von Bearbeitungsstufen (PS1 bis PS201) durchläuft. Es werden auf die Fertigungseinheiten (12) bezogene Werte für eine Gütegröße zur Bewertung der Fertigung ermittelt, z.B. für die Ausbeute. Außerdem wird eine Untersuchungsgröße vorgegeben, z.B. die für die Fertigung verwendete Maschine (M1 bis M3) in einer bestimmten Bearbeitungsstufe (PS1). Signifikanztests werden automatisch (30) für mindestens zwei Bearbeitungsstufen (PS1, PS2) ausgeführt. Anschließend wird automatisch eine Bearbeitungsstufe (PS1) ausgewählt, in der die Ursache für einen Fertigungs- und/oder Prozessierungsfehler gesucht wird.

FIG 1

EP 1 235 270 A2

**Beschreibung**

Die Erfindung betrifft zum Ermitteln von Fertigungs- und/oder Prozessierungsschwächen ein Verfahren, bei dem Fertigungseinheiten eine Vielzahl von Bearbeitungsstufen durchlaufen. Außerdem werden auf Fertigungseinheiten bezogene Werte für eine Gütegröße zur Bewertung der Fertigung ermittelt. Es wird eine Untersuchungsgröße vorgegeben, deren Auswirkung auf die Gütegröße untersucht werden soll. Mit Hilfe von für die Untersuchungsgröße ermittelten Werten wird geprüft, ob die Untersuchungsgröße einen signifikanten Einfluss und/oder eine besondere Einflussstärke bzw. Effektstärke auf die Gütegröße hat, die eine vorgegebene Mindesteinflussstärke überschreitet.

Solche Verfahren werden vor allen Dingen bei sehr komplexen Fertigungen eingesetzt, bei denen eine Vielzahl von Prozessschritten zur Herstellung eines Endproduktes erforderlich sind, beispielsweise mehr als 200 Fertigungsschritte. Die Auswirkung auf die Qualität der einzelnen Fertigungsschritte lässt sich oft erst am fertigen Produkt erfassen. Dann ist es jedoch schwierig, auf die Ursache für einen Fertigungsfehler zurückzuschließen. Ein Beispiel für einen komplexen Fertigungsprozess ist die Fertigung integrierter Schaltkreise. Beispielsweise werden auf einer Halbleiterscheibe, z.B. auf Siliziumbasis, d.h. auf einem sogenannten Wafer, mehrere Strukturschichten erzeugt. Zum Herstellen jeder Schicht muss auf dem Wafer eine Grundschicht abgeschieden werden. Anschließend wird ein Fotolack aufgebracht. Danach wird der Fotolack mit Hilfe einer Maske belichtet. Der belichtete Fotolack wird entwickelt. In einem Ätzschritt wird die zu bearbeitende Schicht dann strukturiert. Zwischen den einzelnen Verfahrensschritten werden weitere Hilfsschritte ausgeführt, z.B. Trocknungsprozesse und Säuberungsprozesse.

Die Fertigungseinheiten sind beispielsweise Fertigungslose, die Halbzeuge enthalten, die als Einheit durch das Fertigungssystem transportiert werden. Andere Fertigungseinheiten sind Fertigungshorden, die Halbzeuge enthalten, die gemeinsam in eine Bearbeitungsmaschine eingebracht werden. Die Fertigungseinheiten können jedoch auch einzelne Halbzeuge sein.

Eine häufig herangezogene Gütegröße bei der Herstellung integrierter Schaltkreise ist die Ausbeute, d.h. das Verhältnis aus der Anzahl funktionsfähiger Chips zur Gesamtanzahl von Chips auf einem Wafer. Jedoch lassen sich auch andere Gütegrößen nutzen.

In der Fertigung sind häufig Fragen zu beantworten wie:

- Hängt die Ausbeute davon ab, ob die Produkte auf einer bestimmten Bearbeitungsmaschine bearbeitet worden sind?
- Hängt die Ausbeute von der Art des hergestellten Schaltkreises ab oder sind Schwankungen der Ausbeute nur darauf zurückzuführen, dass die Schaltkreise auf verschiedenen Bearbeitungsmaschinen produziert worden sind?
- Welche Maschine beeinflusst die Ausbeute am stärksten?

Die Untersuchungsgrößen sind somit die hergestellten Produkte oder die zur Bearbeitung eingesetzten Maschinen. Jedoch gibt es auch viele andere Untersuchungsgrößen, z.B. den Einfluss von Wartungszyklen oder von Fertigungspausen auf die Gütegröße.

Die Beantwortung der Fragen wird dadurch erschwert, dass einzelne Fertigungseinheiten die Produktion aus logistischen Gründen meist in einer anderen Reihenfolge verlassen als in der Reihenfolge, in der sie in die Fertigung eingebracht worden sind. Außerdem werden bestimmte Produkte nur selten gefertigt.

Von der schnellen Beantwortung der Fragen hängt es jedoch ab, ob die Ursache für einen Fehler schnell und mit einem geringen Aufwand an hochspezialisiertem Bedienpersonal gefunden werden kann. Deshalb werden die Verfahren zum Überwachen der Fertigung ständig verbessert. Bisher wurden hauptsächlich statistische Verfahren herangezogen, die parameterbezogen sind, d.h. beispielsweise von der Art der Verteilung zur Beschreibung eines Prozesses, vom Mittelwert einer statistischen Größe, von der Streuung einer statistischen Größe oder von anderen Parametern abhängen. Bekannt sind jedoch auch statistische Testverfahren, die parameterunabhängig sind, z.B. der Kontingenztafeltest, der Chi-Quadrattest, der Kruskal-Wallis-Test oder der Man-Witney-Test.

Es ist Aufgabe der Erfindung, zum Ermitteln von Fertigungs-und/oder Prozessierungsschwächen ein einfaches Verfahren anzugeben, mit dessen Hilfe sich Ursachen für Fertigungs-und/oder Prozessierungsschwächen insbesondere schnell und mit einer hohen Treffsicherheit ermitteln lassen. Außerdem soll ein damit in engem technischem Zusammenhang stehendes Verfahren zum Ermitteln von Maschinentrends angegeben werden. Weiterhin sollen ein zugehöriges Programm, eine zugehörige Datenverarbeitungsanlage und ein zugehöriges Fertigungssystem angegeben werden.

Die auf das Verfahren bezogene Aufgabe wird durch die im Patentanspruch 1 angegebenen Verfahrensschritte gelöst. Weiterbildungen sind in den Unteransprüchen angegeben.

Die Erfindung geht von der Überlegung aus, dass es bei der Einbeziehung nur einer Bearbeitungsstufe in die Untersuchung nur vom Glück bzw. von der Größe des Spezialwissens bei der Auswahl der Bearbeitungsstufe abhängt, ob zunächst ein signifikanter Einfluss ermittelt werden kann und ob dann beim Vorliegen eines signifikanten Einflusses die untersuchte Bearbeitungsstufe tatsächlich die Ursache für eine auftretende Fertigungs- und/oder Prozessierungsschwäche ist. Deshalb werden beim erfindungsgemäßen Verfahren zusätzlich zu den eingangs genannten Verfahrensschritten mindestens zwei Bearbeitungsstufen oder mindestens zwei Bearbeitungsabschnitte aus aufeinanderfolgenden Bearbeitungsstufen untersucht, in denen automatisch die Signifikanz und/oder die Einflussstärke der Untersuchungsgröße auf die Gütegröße ermittelt wird. Weiterhin wird beim erfindungsgemäßen Verfahren automatisch abhängig von der Signifikanz und/oder der Einflussstärke der Auswirkungen der Untersuchungsgröße auf die Gütegröße je Bearbeitungsstufe bzw. je Bearbeitungsabschnitt eine Auswahl einer Bearbeitungsstufe bzw. eines Bearbeitungsabschnittes getroffen, in dem dann die Ursache für einen Prozessierungs-und/oder Fertigungsfehler gesucht wird.

So lassen sich die signifikanten Werte und/oder die Einflussstärken der Größe nach sortieren. Unterscheidet sich der größte Signifikanzwert bzw. der größte Effektwert sehr stark von den übrigen Werten, so wird nur eine Bearbeitungsstufe bzw. nur ein Bearbeitungsabschnitt untersucht. Sind die größten Signifikanzwerte bzw. Einflussstärken von der gleichen Größenordnung, so wird die Ursache für die Fertigungsund/oder Prozessierungsschwäche in mehreren Bearbeitungsstufen gesucht. Bearbeitungsstufen, deren Signifikanzwerte und/oder Einflussstärken auf den weiteren Plätzen der Sortierreihenfolge liegen, werden in einer Speichereinheit vermerkt. Für diese Bearbeitungsstufen lassen sich Warnungen ausgeben. Werden wiederholt Warnungen bzw. Vermerke für bestimmte Bearbeitungsstufen erzeugt, so werden auch diese Bearbeitungsstufen in die Suche nach dem Fehler einbezogen.

Bei einer Weiterbildung des erfindungsgemäßen Verfahrens werden nur solche Bearbeitungsstufen und/oder Bearbeitungsabschnitte in das Ermitteln der Signifikanz und/oder der Einflussstärke einbezogen, in denen die Untersuchungsgröße mehrere Ausprägungen hat. Durch diese Maßnahme lässt sich der rechentechnische Aufwand beim Ermitteln der Signifikanz und/oder der Einflussstärke erheblich verringern, weil nur ein Teil der Bearbeitungsstufen berücksichtigt werden muss. Insbesondere bei Fertigungsprozessen mit über 200 Bearbeitungsstufen ist das Einbeziehen von beispielsweise nur 100 Bearbeitungsstufen selbst bei sehr schneller Rechentechnik von großem Vorteil.

Bei einer anderen Weiterbildung des erfindungsgemäßen Verfahrens wird der überwiegende Teil der Bearbeitungsstufen und/oder der Bearbeitungsabschnitte untersucht, in denen ein Einfluss der Untersuchungsgröße auf die Gütegröße erwartet wird. Der überwiegende Teil bedeutet, mehr als 50% aller Bearbeitungsstufen, üblicherweise über 80 % und vorzugsweise mehr als 90%. Werden nur Bearbeitungsstufen betrachtet, in denen die Untersuchungsgröße mehrere Ausprägungen hat, so bezieht sich der Ausdruck "der überwiegende Teil" nur auf diese Bearbeitungsstufen. Die betreffenden Bearbeitungsstufen bzw. Bearbeitungsabschnitte lassen sich empirisch auswählen oder aufgrund der für den Fertigungsprozess geltenden physikalischen Zusammenhänge. Nach einer einmaligen manuellen Vorgabe lässt sich die Auswahl automatisch ausführen, wenn die ausgewählten Bearbeitungsstufen oder Bearbeitungsabschnitte in einer Speichereinheit vermerkt werden. Alternativ wird jedoch zumindest der überwiegende Teil der Bearbeitungsstufen und/oder der Bearbeitungsabschnitte unabhängig davon untersucht, ob ein Einfluss der Untersuchungsgröße auf die Gütegröße erwartet wird oder nicht. Durch diese Vorgehensweise lassen sich auch unerwartete Einflussfaktoren aufdecken.

Bei einer nächsten Weiterbildung werden alle Bearbeitungsstufen oder alle Bearbeitungsstufen mit mehreren Ausprägungen der Untersuchungsgröße bzw. lückenlos aufeinanderfolgende Bearbeitungsabschnitte oder lückenlos aufeinanderfolgende Bearbeitungsabschnitte untersucht, in denen die Untersuchungsgröße mehrere Ausprägungen hat. Damit ist gewährleistet, dass die Untersuchung vollständig ist, und dass das Ergebnis tatsächlich die für die Beantwortung der Untersuchungsfrage relevanteste Bearbeitungsstufe bzw. den relevantesten Bearbeitungsabschnitt anzeigt. Bei einer Ausgestaltung werden innerhalb eines Fertigungsabschnitts, der für die Fehlerursache in Betracht kommen kann, oder innerhalb der gesamten Fertigung lückenlos Bearbeitungsstufen und/oder Bearbeitungsabschnitte untersucht, in denen die Untersuchungsgröße einen Einfluss auf die Gütegröße haben kann. Durch das lückenlose Einbeziehen lässt sich die Trefferquote bei der Suche nach Fehlerursachen von dem Zufallselement befreien, das durch die Auswahl bestimmter Bearbeitungsstufen und/oder Bearbeitungsabschnitte in die Untersuchung eingebracht werden würde. Alternativ werden jedoch lückenlos alle Bearbeitungsstufen und/oder lückenlos Bearbeitungsabschnitte unabhängig davon untersucht, ob ein Einfluss der Untersuchungsgröße auf die Gütegröße erwartet wird oder nicht. Durch diese Vorgehensweise lassen sich auch unerwartete Einflussfaktoren sicher aufdecken.

Bei einer anderen Weiterbildung werden zur Feststellung der Signifikanz und/oder der Einflussstärke nichtparametrische Tests eingesetzt, d.h. Tests, die nicht von einem vorher unter Umständen sehr aufwendig zu ermittelnden Parameter abhängen, z.B. von einem Mittelwert, einer Streuung oder der Art einer Verteilung. Durch das Verwenden nichtparametrischer Tests steigt die Trefferquote bei der Ermittlung von Fehlerursachen weiter.

Bei einer anderen Weiterbildung werden zur Feststellung der Signifikanz und/oder der Einflussstärke parametrische Tests eingesetzt. Vor Ausführung des Tests werden bei einer Ausgestaltung automatisch Ausreißer aus den Werten für die Untersuchungsgröße entfernt. Ausreißer sind solche Werte, die sich erheblich von den anderen Werten der Untersuchungsgröße unterscheiden, beispielsweise mehr als doppelt so groß sind oder nur die Hälfte des Wertes der anderen Untersuchungsgrößen haben. Durch das Beseitigen von Ausreißern lässt sich vermeiden, dass die sehr sensibel reagierenden parametrischen Tests nicht verfälscht werden. Die Ausreißer lassen sich manuell oder automatisch entfernen.

Bei einer nächsten Weiterbildung des erfindungsgemäßen Verfahrens wird die Verteilung der Werte der Untersuchungsgröße unter Berücksichtigung einer Rangfolge dieser Werte jedoch unter Beibehaltung der Monotonie der Verteilung geändert. Durch das Berücksichtigen einer Rangfolge lässt sich die Aussagesicherheit von statistischen Tests in vielen Fällen erheblich steigern.

Bei einer anderen Weiterbildung wird bei dem Test zum Ermitteln der Signifikanz eine Bonferroni-Korrektur durchgeführt. Durch das Verwenden einer Bonferroni-Korrektur lassen sich Bearbeitungsstufen mit einem tatsächlichen Einfluss auf die Gütegröße von Bearbeitungsstufen mit einem nur scheinbaren Einfluss auf die Untersuchungsgröße unterscheiden. Wurden beispielsweise mit den statistischen Tests einhundert Bearbeitungsstufen ermittelt, in denen die Untersuchungsgröße einen signifikanten Einfluss auf die Gütegröße hat, so bleiben nach dem Ausführen der Bonferroni-Korrektur nur noch beispielsweise zehn Bearbeitungsstufen mit einem signifikanten Einfluss übrig. Durch die Bonferroni-Korrektur lässt sich die Trefferquote erheblich erhöhen. Im Zusammenhang mit der Bonferroni-Korrektur wird auf das Buch "Multivariante statistische Verfahren", Ludwig Fahrmeir, Walter de Gruyter, Berlin, 1996, 2. Auflage, Kapitel 4.2 "Der Union-Intersection-Test und simultane Konfidenzintervalle", Seite 90 bis Seite 92 verwiesen. Gemäß den Ausführungen auf Seite 92 ist das zunächst ermittelte Signifikanzniveau durch die Anzahl der in der betreffenden Bearbeitungsstufe für die Untersuchungsgröße ermittelten Werte zu teilen. Außerdem wird im Zusammenhang mit der Bonferroni-Korrektur auf das Handbuch "SPSS for Windows, CHAID, Relief 6.0", Jay Magidson/ SPSS Inc., 1993, Statistical Innovation Incorporation, Seiten 132 und 133, hingewiesen. SPSS ist eine Abkürzung für Statistical Package for Social Sciences. Das Statistikpaket SPSS wird heute jedoch in fast allen Bereichen für statistische Untersuchungen eingesetzt. Auch die im Zusammenhang mit der Erfindung erforderlichen statistischen Tests lassen sich mit dem Programmpaket SPSS ausführen.

Bei einer anderen Weiterbildung betreffen die Werte der Untersuchungsgrößen Fertigungseinheiten zur Herstellung verschiedener Produktarten. Demzufolge lässt sich das erfindungsgemäße Verfahren oder eine Weiterbildung in einem Fertigungsprozess einsetzen, in dem gleichzeitig Fertigungseinheiten für verschiedene Produkte gefertigt werden. Jedoch wird das erfindungsgemäße Verfahren bzw. eine seiner Weiterbildungen alternativ auch dann eingesetzt, wenn die Werte der Untersuchungsgröße bzw. der Untersuchungsgrößen nur Fertigungseinheiten zur Herstellung eines Produktes betreffen.

Eine erste Gruppe von Untersuchungsgrößen betrifft gemäß einer nächsten Weiterbildung einen Zeitpunkt, einen Zeitabschnitt, eine Zeitdifferenz oder eine Zeitperiode. Durch die Einbeziehung solcher Untersuchungsgrößen lassen sich beispielsweise Einflüsse von Wartungszyklen oder von Fertigungspausen untersuchen.

Bei einer Weiterbildung ist die Untersuchungsgröße die Zeitdifferenz zwischen vorgegebenen Bearbeitungsstufen oder zwischen vorgegebenen Bearbeitungsabschnitten. Solche Untersuchungen werden auch als Zeitdifferenzuntersuchungen bezeichnet.

Bei einer Weiterbildung einer Zeitdifferenzuntersuchung wird zum Ermitteln der Signifikanz und/oder der Einflussstärke ein Median-Test oder ein Kruskal-Wallis-Test eingesetzt. Gerade bei Zeitdifferenzuntersuchungen sind diese Tests besonders gut geeignet, um Bearbeitungsstufen zu finden, in denen die Verteilung der Werte der Untersuchungsgröße nicht auf einen Zufallsprozess zurückzuführen ist. Ist die Verteilung nämlich nicht zufällig, so muss es eine andere Ursache für die Verteilung geben, z.B. die gesuchte Fehlerursache.

Bei einer anderen Weiterbildung betrifft die Untersuchungsgröße die zeitliche Periode von Schwankungen der Gütegröße. Durch die Wahl dieser Untersuchungsgröße lassen sich der Einfluss von Wartungszyklen oder von anderen Zyklen erkennen.

Bei einer Ausgestaltung, bei der die Untersuchungsgröße die zeitliche Periode von Schwankungen der Gütegröße betrifft, werden je untersuchter Bearbeitungsstufe die Fertigungseinheiten gemäß ihrer Bearbeitungsreihenfolge geordnet. Anschließend wird eine Transformation der Gütegröße aus dem Zeitbereich in den Frequenzbereich ausgeführt. Abhängig von den transformierten Werten wird dann eine Bearbeitungsstufe ausgewählt, die die Schwankung hervorruft. Diese Weiterbildung geht von der Überlegung aus, dass die Umordnung der Fertigungseinheiten beim Durchlaufen des Fertigungsprozesses für die Suche von Ursachen für Schwankungen genutzt werden kann. Die Schwankungen sind nämlich in den Bearbeitungsstufen bzw. Bearbeitungsabschnitten am deutlichsten, in denen sie hervorgerufen werden. Durch das Umordnen der Fertigungseinheiten sind die Schwankungen in nachfolgenden Bearbeitungsstufen oder in vorhergehenden Bearbeitungsstufen nicht so deutlich ausgeprägt. Insbesondere wenn alle Bearbeitungsstufen und/oder Bearbeitungsabschnitt einbezogen werden, in denen Schwankungen hervorgerufen werden können, lässt sich durch die Wahl eines geeigneten Schwellwertes die Bearbeitungsstufe bzw. der Bearbeitungsabschnitt exakt ermitteln, in der bzw. in dem die Schwankung tatsächlich hervorgerufen wird. Die Trefferquote steigt also im Vergleich zu bekannten Verfahren erheblich. Zufallsmomente werden weitgehend ausgeschaltet.

Bei einer anderen Gruppe von Untersuchungsgrößen ist die Untersuchungsgröße der Verlauf der Gütegröße abhängig von der Reihenfolge der Bearbeitung der Fertigungseinheiten bezogen auf eine Bearbeitungsstufe oder bezogen auf einen Bearbeitungsabschnitt. Diese Weiterbildung geht ebenfalls von der Überlegung aus, dass sich das Umordnen der Fertigungseinheiten beim Durchlaufen der Fertigung für das Ermitteln von Fertigungs- und/oder Prozessierungsschwächen ausnutzen lässt. Wird nämlich der Verlauf der Gütegröße durch einen Fehler in einer bestimmten Bearbeitungsstufe beeinflusst, so ist dieser Einfluss in der betreffenden Bearbeitungsstufe am größten. Durch das Umordnen in den folgenden Bearbeitungsstufen wird der Einfluss wieder verzerrt und durch zufällige Einflussgrößen überlagert. Auch in vorhergehenden Bearbeitungsstufen ist der Einfluss auf den Verlauf der Gütegröße nicht so deutlich.

Bei einer Ausgestaltung wird die Glattheit des Verlaufs als Untersuchungsgröße gewählt. Als Maß für die Glattheit lässt sich beispielsweise die Kurvenlänge des Verlaufs der Gütegröße in einem bestimmten Zeitabschnitt wählen. Jedoch wird an Stelle der Kurvenlänge auch eine Näherung für die Kurvenlänge eingesetzt, die sich durch robustere Rechenverfahren und vor allem auch durch einfachere Rechenverfahren ermitteln lässt als die Kurvenlänge selbst.

Bei einer Ausgestaltung berechnet sich die Näherung nach der folgenden Formel:

$$m(op)=1/N \text{ Summe } |f(t+1)-f(t)| \text{ von } t=1 \text{ bis } N,$$

wobei $m(op)$ die genäherte Länge des Verlaufs, $t$ die Position in der Reihenfolge, $f(t)$ die Gütegröße der Fertigungseinheit an der Position $t$, $op$ die Bearbeitungsstufe oder den Bearbeitungsabschnitt und $N$ die Gesamtzahl der betrachteten Fertigungseinheiten bezeichnen. Durch die Formel (1) lässt sich die Kurvenlänge sehr gut und durch einfache Rechenoperationen annähern. Es wird die Bearbeitungsstufe für die weitere Untersuchung ausgewählt, in der die Näherung $m(op)$ den kleinsten Wert hat.

Bei einer anderen Gruppe von Untersuchungen betrifft die Untersuchungsgröße die Abhängigkeit der Gütegröße von der zur Bearbeitung der Fertigungseinheiten ausgewählten Bearbeitungsmaschine aus einer Gruppe mehrerer Bearbeitungsmaschinen, die zur Ausführung der gleichen Bearbeitungsstufe dienen. Die Ausbeute wird beispielsweise sehr oft dadurch beeinflusst, dass eine bestimmte Bearbeitungsmaschine besser bearbeitet als eine andere Bearbeitungsmaschine der gleichen Bearbeitungsstufe. Lässt sich eine Bearbeitungsstufe ermitteln, in der die Bearbeitung von der gewählten Bearbeitungsmaschine abhängt, so lässt sich durch das Bearbeiten von Testhalbzeugen und eine anschließende Vermessung auf einfache Art bestätigen, dass die im Test auffällige Bearbeitungsmaschine die Fertigungsschwäche tatsächlich verursacht hat. Alternativ oder kumulativ ist die Untersuchungsgröße ein Prozessparameter. Der Prozessparameter ist vorzugsweise gruppierbar. Beispielsweise lässt sich die Ätzrate in schnell, mittel und langsam gruppieren.

Wird die Abhängigkeit der Gütegröße von der zur Bearbeitung ausgewählten Bearbeitungsmaschine untersucht, so wird als Test eine Kontingenztafel-Analyse oder ein Kruskal-Wallis-Test eingesetzt. Diese Tests sind für die Untersuchung auf Abhängigkeit von der zur Bearbeitung genutzten Maschine besonders gut geeignet. Die Trefferquote bei der Suche nach Fehlerursachen ist ausreichend hoch.

Bei einer anderen Weiterbildung wird mindestens ein alternativer Prozessierungsweg wie eine zusätzliche Maschine bzw. wie eine zusätzliche Prozessparametergruppe in den Test einbezogen. Ein alternative Prozessierungsweg wird dadurch gebildet, dass dort, wo bisher nur eine Bearbeitungsmaschine eingesetzt worden ist, nun zwei Bearbeitungsmaschinen eingesetzt werden. Alternativ werden aber bei einer Neuerung beispielsweise die bisher durch mehrere Bearbeitungsmaschinen erbrachten Schritte durch eine Bearbeitungsmaschine erbracht. Bei der Umstellung der Produktion lässt sich der Einfluss dieser Umstellung auf die Gütegröße durch die Weiterbildung ermitteln. Es werden also nicht nur Einflüsse von Bearbeitungsmaschinen einer Bearbeitungsstufe sondern auch Einflüsse alternativer Prozessierungswege untersucht.

Bei einer nächsten Gruppe von Untersuchungen wird als Untersuchungsgröße eine Maschine gewählt, deren Maschinentrend untersucht werden soll, d.h. die Richtung, in der sich die mit einer Maschine erreichte Bearbeitungsqualität verändert. Die für die auf einer Maschine bearbeiteten Fertigungseinheiten erfassten Werte der Gütegröße werden in eine Reihenfolge gebracht, die der Bearbeitung der zu den Werten gehörenden Fertigungseinheiten entspricht. Durch das Skalieren dieser Werte auf ein vorgegebenes Intervall, z.B. auf das Intervall von -1 bis +1 und/oder durch das Zentrieren bezüglich der Zeitachse um den Wert Null und/oder durch das Berücksichtigen einer Rangreihenfolge lassen sich bei einer automatisch ausgeführten Regressionsrechnung Angaben über den Maschinentrend mit einer hohen Sicherheit und mit einer hohen Genauigkeit erreichen. Außerdem sind die Ergebnisse der Regressionsrechnung für verschiedene Maschinen untereinander vergleichbar.

Zur Vorhersage des Maschinentrends wird insbesondere eine lineare Regression eingesetzt. Durch das Skalieren auf ein vorgegebenes Intervall wird erreicht, dass eine einheitliche Vergleichsbasis entsteht, auf der mehrere Maschinen untereinander bezüglich des Maschinentrends verglichen werden. Durch das Zentrieren wird gewährleistet, dass die bei der Regression bestimmten Parameter im mittleren Bereich der Werte liegen. So gibt bei einer Zentrierung und einer linearen Regression der Achsenschnittpunkt auf der y-Achse den Mittelwert der Gütegröße auf der betrachteten Bearbeitungsmaschine an. Damit lässt sich der Mittelwert ohne zusätzliche statistische Betrachtungen auf einfache Art ermitteln. Signifikanzwerte für den Mittelwert ergeben sich bereits bei der Regression. Das Berücksichtigen der Rangreihenfolge führt dazu, dass die Werte der Untersuchungsgröße die Regression unabhängig von dem tatsächlichen Bearbeitungszeitpunkt beeinflussen. Die tatsächlichen Bearbeitungszyklen sind nämlich sehr oft ungleichmäßig verteilt, ohne dass sich darauf eine besondere Wirkung auf den Maschinentrend ergeben würde.

Bei der Untersuchung von Maschinentrends ist oft die Frage zu beantworten, welche der in einem komplexen Fertigungsprozess eingesetzten Maschine ihre Bearbeitungsqualität besonders schnell und besonders stark verringern. Diese Maschinen sind dann die Schwachpunkte, an denen Fehlerursachen gesucht werden müssen. Nach der Beseitigung dieser Fehlerursachen verbessern sich die Werte der Gütegröße oft erheblich. Andererseits sind auch Maschinen von Interesse, an denen die Bearbeitungsqualität plötzlich ansteigt. An diesen Maschinen lassen sich Verbesserungspotentiale aufdecken.

Das Verfahren zum Ermitteln von Maschinentrends ist auch ein eigener Aspekt der Erfindung. Das Verfahren lässt sich für eine einzelne Maschine ausführen. Jedoch werden die besten Ergebnisse dann erzielt, wenn das Verfahren gemäß dem zweiten Aspekt mit dem erfindungsgemäßen Verfahren gemäß dem ersten Aspekt oder mit einer seiner Weiterbildungen kombiniert wird.

Die erfindungsgemäßen Verfahren oder ihre Weiterbildungen werden insbesondere bei der Herstellung von integrierten Schaltkreisen eingesetzt. Die Ermittlung von Fertigungsund/oder Prozessierungsschwächen ist gerade bei der Herstellung von integrierten Schaltkreisen besonders schwierig, weil das Innere des integrierten Schaltkreises nur mit teuren Durchstrahlungsverfahren oder durch eine Zerstörung des integrierten Schaltkreises und anschließenden Einsatz von ebenfalls teuren Messverfahren zugänglich ist. Zwar wird das erfindungsgemäße Verfahren bzw. einer seiner Weiterbildungen auch bei der Herstellung von anderen komplexen Produkten eingesetzt, wie z.B. bei der Herstellung von Kraftfahrzeugen, jedoch werden die Vorteile dann besonders groß sein, wenn die Ermittlung der Fertigungs- und/oder Prozessierungsschwächen allein am Produkt nicht ohne weiteres möglich ist.

Bei einer anderen Weiterbildung der erfindungsgemäßen Verfahren oder ihrer Weiterbildungen werden sämtliche Verfahrensschritte automatisch ausgeführt. Bedienpersonen werden somit weitgehend entlastet.

Die Erfindung betrifft außerdem ein Programm, eine Datenverarbeitungsanlage und ein Fertigungssystem, die zur Ausführung eines der erfindungsgemäßen Verfahren bzw. einer Weiterbildung geeignet sind und für die die oben genannten technischen Wirkungen ebenfalls gelten.

Im Folgenden werden Ausführungsbeispiele der Erfindung an Hand der beiliegenden Zeichnungen erläutert. Darin zeigen:

Figur 1                  ein Prozesssystem zur Herstellung integrierter Schaltkreise,

Figur 2                  eine Untersuchungseinheit zum automatischen Ermitteln von Fertigungs- und/oder Prozessierungsschwächen,

Figur 3                  ein Beispiel für eine Zeitdifferenzuntersuchung mit Hilfe eines Median-Testes,

Figur 4                  das Ermitteln der Ursache für eine periodische Schwankung der Ausbeute mit Hilfe der Fourier-Transformation,

Figuren 5A und 5B     eine sogenannte ZOOM-Analyse zum Ermitteln einer Fertigungsschwäche,

Figur 6                  eine Kontingenztafel-Analyse zum Ermitteln des Einflusses der für die Bearbeitung in einer Bearbeitungsstufe ausgewählten Maschine auf die Ausbeute,

Figur 7                  alternative Prozessierungswege, die auf eine Prozessierungsschwäche hin untersucht werden, und

Figur 8                  eine Maschinentrendanalyse.

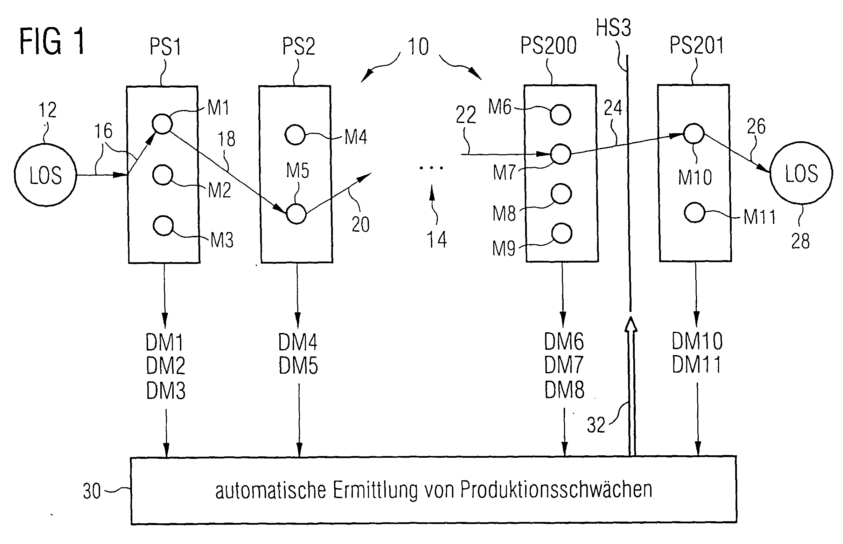

Figur 1 zeigt ein Prozesssystem 10 zur Herstellung integrierter Schaltkreise. Das Prozesssystem 10 enthält in einer Fertigungshalle mehr als zweihundert Prozessstufen PS1 bis PS201. Die Bearbeitungsstufen PS1 bis PS201 dienen zur Bearbeitung von Fertigungseinheiten, beispielsweise von Fertigungslosen, von denen in Figur 1 ein Fertigungslos 12 dargestellt ist. Ein Fertigungslos enthält beispielsweise 25 oder 50 Wafer. Die Wafer eines Fertigungsloses 12 werden gemeinsam durch die Prozessstufen PS1 bis PS201 transportiert. Beim Transport der Fertigungslose 12 durch das Prozesssystem 10 wird die Reihenfolge verändert, in der die Fertigungslose 12 ursprünglich in das Prozesssystem 10 eingebracht werden.

Die Prozessstufen PS1 bis PS201 dienen beispielsweise zur Ausführung von Belichtungsprozessen, Ätzprozessen, Trocknungsprozessen, Hilfsprozessen oder Dotierungsprozessen. Zwischen den einzelnen Prozessstufen PS1 bis PS201 werden noch Hilfsschritte ausgeführt, von denen in Figur 1 ein Hilfsschritt HS3 dargestellt ist, der zum Prüfen der integrierten Schaltkreise auf den Wafern dient.

In der Prozessstufe PS1 gibt es drei Maschinen M1 bis M3, die zur Ausführung des gleichen Bearbeitungsschrittes verwendet werden können. Die Maschinen M1 bis M3 sind gleich aufgebaut. In der Prozessstufe PS2 werden zwei Maschinen M4 und M5 eingesetzt, die den gleichen Bearbeitungsschritt ausführen. Jedoch ist die Maschine M4 ein älteres Modell der Maschine M5. Zwischen den Prozessstufen PS2 und PS200 liegende Prozessstufen 14 sind durch Punkte angedeutet. Einzelne Prozessstufen 14 enthalten nur eine einzige Bearbeitungsmaschine. In anderen Prozessstufen 14 gibt es dagegen mehrere Bearbeitungsmaschinen, die alternativ zur Bearbeitung der Fertigungslose in dieser Prozessstufe eingesetzt werden.

Die Prozessstufe PS200 enthält vier Maschinen M6 bis M9, die alternativ zur Prozessierung eingesetzt werden. In der Prozessstufe 201 gibt es zwei Maschinen M10 und M11, die alternativ zur Bearbeitung eingesetzt werden.

Das Fertigungslos 12 wird zunächst in der Prozessstufe PS1 bearbeitet und zwar mit Hilfe der Maschine M1, siehe Pfeile 16. Anschließend wird das teilweise bearbeitete Fertigungslos 12 zur Prozessstufe PS2 transportiert, siehe Pfeil 18. In der Prozessstufe PS2 wird das Fertigungslos 12 Hilfe der Maschine M5 bearbeitet. Anschließend durchläuft das Fertigungslos 12 die Prozessstufen 14, siehe Pfeile 20 und 22.

Nach dem Durchlaufen der Prozessstufen 14 wird das Fertigungslos 12 in der Prozessstufe PS200 mit Hilfe der Maschine M7 bearbeitet. Danach wird das Fertigungslos im Hilfsschritt HS3 geprüft und dann zur Prozessstufe PS201 transportiert, siehe Pfeil 24. In der Prozessstufe PS201 wird der letzte Bearbeitungsschritt am Fertigungslos 12 mit Hilfe der Maschine M10 ausgeführt. Anschließend wird das Fertigungslos 12 aus dem Prozesssystem 10 ausgeschleust, siehe Pfeil 26. Aus dem Fertigungslos 12 wurde ein bearbeitetes Fertigungslos 28.

Andere, in Figur 1 nicht dargestellte Fertigungslose, werden beim Durchlaufen der Prozessstufen PS1 bis PS201 mit anderen Maschinen M1 bis M11 bearbeitet, als das Fertigungslos 12. Auch gibt es Fertigungslose, die nur einen Teil der Prozessstufen PS1 bis PS201 durchlaufen.

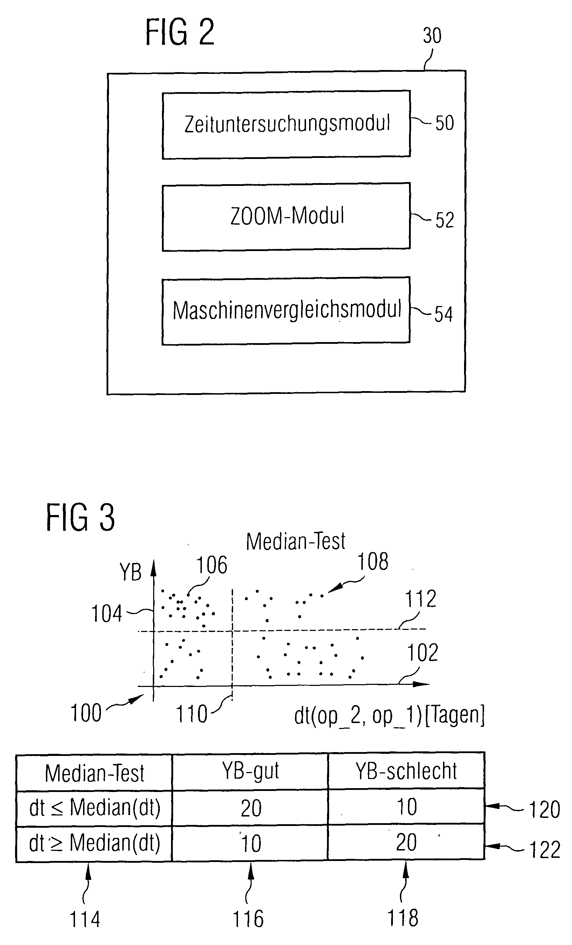

Beim Bearbeiten eines Fertigungsloses 12 in dem Prozesssystem 10 erzeugt jede Maschine M1 bis M11 Maschinendaten DM1 bis DM11, in denen die Losenummer L des bearbeiteten Fertigungsloses 12, die Bearbeitungszeit, das Bearbeitungsdatum und für die Bearbeitung ausschlaggebende Prozessparameter enthalten sind, wie z.B. eine Temperatur, die Zusammensetzung eines Ätzmittels oder andere Angaben. Die Maschinendaten DM1 bis DM11 werden von den Maschinen M1 bis M11 über ein nicht dargestelltes lokales Datenübertragungsnetz, z.B. ein Ethernet, zu einer Untersuchungseinheit 30 übertragen, in denen die Maschinendaten DM1 bis DM11 nach dem unten an Hand der Figuren 2 bis 8 erläuterten Verfahren untersucht werden, um Fertigungs- und/oder Prozessierungsschwächen zu ermitteln. Die Untersuchungseinheit 30 erzeugt beispielsweise auf einer Anzeigeeinheit einen Hinweis 32 für eine Bedienperson. Der Hinweis 32 deutet auf die Prozessstufe PS1 bis PS201 bzw. den Hilfsprozess hin, der wahrscheinlich die Ursache für den Rückgang der Ausbeute YB bildet. Bei dem in Figur 1 dargestellten Ausführungsbeispiel betrifft der Hinweis 32 den Hilfsschritt HS3.

Durch nähere Untersuchung der durch den Hinweis 32 bezeichneten Prozessstufe PS1 bis PS201 bzw. des bezeichneten Hilfsschrittes mit Hilfe von statistischen Folgetests, oder mit Hilfe von Testwafern, lässt sich dann die Fehlerursache weiter eingrenzen.

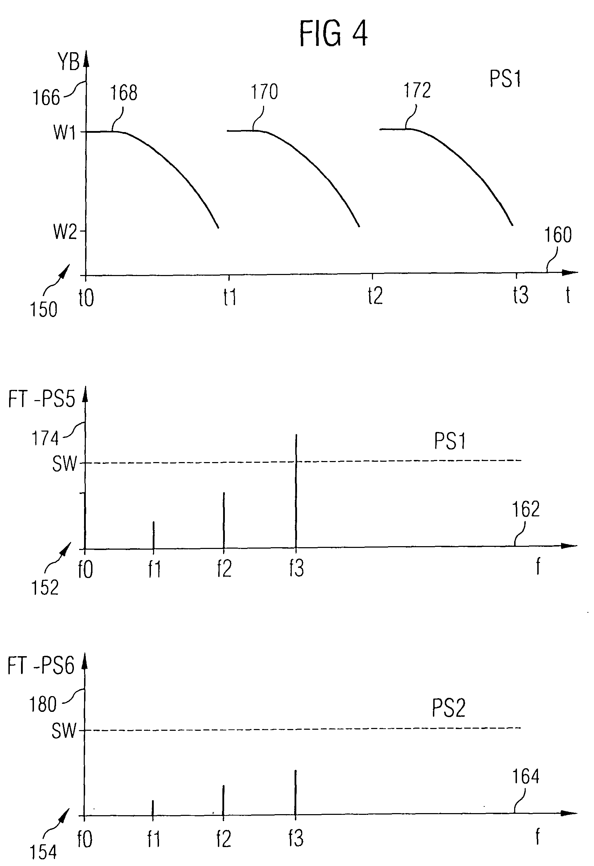

Figur 2 zeigt Teilsysteme der Untersuchungseinheit 30 zum automatischen Ermitteln von Fertigungs- und/oder Prozessierungsschwächen. Die Untersuchungseinheit 30 enthält ein Zeituntersuchungsmodul 50, ein sogenanntes ZOOM-Modul 52 (Zeitordnungs-Optimierungs-Methode) und ein Maschinenvergleichsmodul 54. Die Untersuchungseinheit 30 lässt sich ausschließlich mit Hilfe einer Hardware oder auch unter Verwendung von Software realisieren. Mit Hilfe des Zeituntersuchungsmoduls 50 lassen sich Untersuchungsgrößen untersuchen, die Zeitpunkte, Zeitabschnitte oder Zeitperioden betreffen. Abhängig von der gewählten Fragestellung lässt sich ermitteln, wie die betreffende Untersuchungsgröße eine Gütegröße beeinflusst, z.B. die Ausbeute YB. Beispiele für Untersuchungen, die mit Hilfe des Zeituntersuchungsmoduls 50 durchgeführt werden, werden unten an Hand der Figuren 3 und 4 erläutert.

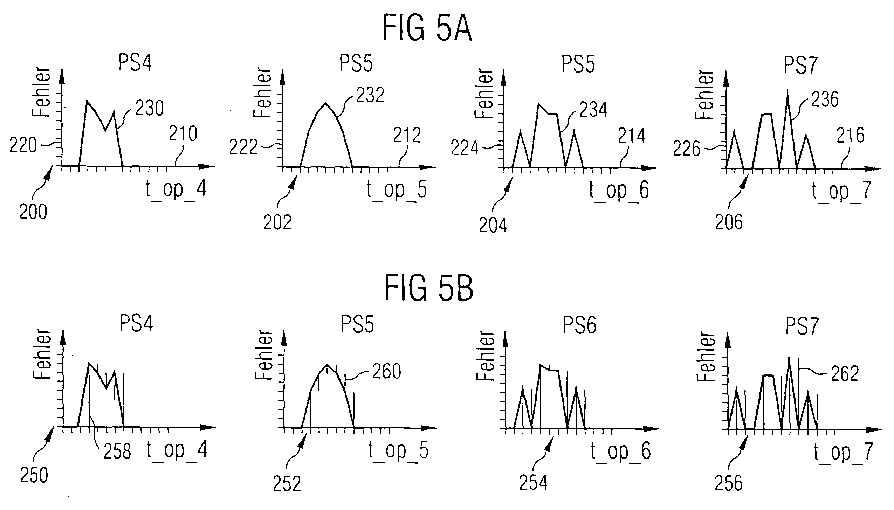

Mit Hilfe des ZOOM-Moduls 52 wird eine Zeitordnungs-Optimierungs-Methode ausgeführt, die unten an Hand der Figuren 5A und 5B näher erläutert wird. Mit Hilfe des ZOOM-Moduls 52 lassen sich Schwächen der Fertigung und/oder der Prozessierung an Hand von Untersuchungen des Verlaufs der Gütegröße abhängig von der Zeit bezogen auf einzelne Bearbeitungsstufen oder Hilfsschritte PS1 bis PS201 ausführen.

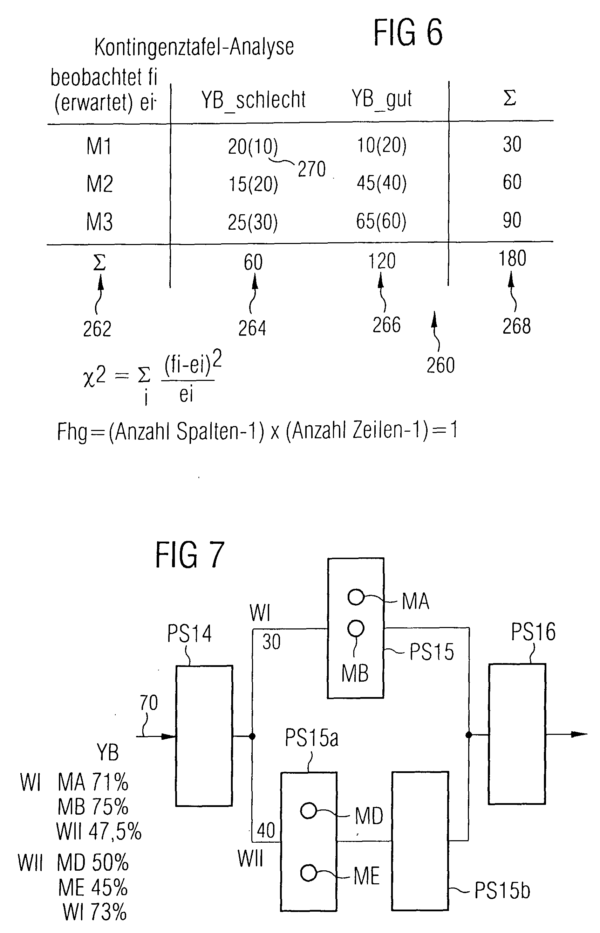

Das Maschinenvergleichsmodul 54 dient zum Beantworten von Fragestellungen, bei denen die Abhängigkeit der Gütegröße von der für die Bearbeitung ausgewählten Maschine untersucht werden soll. Beispiele für Untersuchungen, die mit Hilfe des Maschinenvergleichsmoduls 54 ausgeführt werden, sind unten an Hand der Figuren 6 bis 8 näher erläutert.

Figur 3 zeigt ein Beispiel für eine mit Hilfe des Zeituntersuchungsmoduls 50 ausgeführte Zeitdifferenzuntersuchung. Im Rahmen der Zeitdifferenzuntersuchung wird der aus der Statistik bekannte Median-Test ausgeführt. Es soll die Frage beantwortet werden, ob die Ausbeute YB von der für die jeweiligen Fertigungslose zwischen den Prozessstufen PS1 und PS2 liegenden Zeit abhängt. Zur Beantwortung der Frage werden die von den Maschinen M1 bis M5 für sechzig Fertigungslose gelieferten Daten ausgewertet. In einem Koordinatensystem 100 ist auf der horizontalen x-Achse 102 die Zeit zwischen aufeinanderfolgenden Prozessstufen PS1 und PS2 je Fertigungslos in Tagen abgetragen. Auf der vertikalen y-Achse 104 des Koordinatensystems 100 ist die Ausbeute YB für die betreffenden Fertigungseinheiten dargestellt, siehe beispielsweise Fertigungseinheit 106. Die Darstellung aller Werte zeigt eine Punktwolke 108 mit sechzig Punkten.

In Figur 3 sind in dem Koordinatensystem 100 außerdem die Werte für den Median der Zeit zwischen den aufeinanderfolgenden Prozessstufen PS1 und PS2 sowie der Median der Ausbeutewerte YB dargestellt, siehe vertikale Linie 110 und horizontale Linie 112. In einer Tabelle 114 sind die für den Median-Test verwendeten Ausgangsdaten dargestellt. Eine Spalte 116 der Tabelle 114 betrifft Fertigungseinheiten, deren Ausbeute YB als gut eingeschätzt wird, weil ihre Ausbeute YB oberhalb des Medians für die Ausbeute, d.h. auch oberhalb der horizontalen Linie 112 liegt. In einer Spalte 118 ist die Anzahl der Fertigungseinheiten dargestellt, deren Ausbeute YB als schlecht eingestuft wurde, weil die Ausbeute unterhalb des Medianwertes für die Ausbeute YB liegt. Die erste Zeile 120 der Tabelle 114 betrifft Fertigungseinheiten, bei denen die Zeit zwischen den Prozessschritten PS1 und PS2 kleiner als der durch die vertikale Linie 110 angedeuteten Medianwert für die zwischen den Prozessen PS1 und PS2 liegende Zeit oder gleich diesem Medianwert ist. Die darunter liegende Zeile 122 betrifft dagegen die Fertigungseinheiten, die oberhalb des Medianwertes für die Zeit zwischen den aufeinanderfolgenden Prozessschritten liegt.

Wie aus der Tabelle 114 ersichtlich, wurden 20 Fertigungseinheiten mit guter Ausbeute YB ermittelt, bei denen die Zeit zwischen den Prozessschritten PS1 und PS2 kleiner als der Median für die Zwischenzeit oder gleich diesem Median war. Zehn Fertigungseinheiten hatten eine schlechte Ausbeute YB, obwohl ihre Verweildauer zwischen den Prozessstufen PS1 und PS2 kleiner als der Medianwert für die Zwischenzeit war. Zehn Fertigungseinheiten hatten eine gute Ausbeute YB und wurden mit einer Zeit zwischen den Prozessschritten PS1 und PS2 produziert, die größer als der.Medianwert für die Zwischenzeit war. 20 Fertigungseinheiten hatten eine schlechte Ausbeute YB und wurden mit einer über dem Median der Zwischenzeit liegenden Zeit zwischen den Prozessstufen PS1 und PS2 prozessiert.

Mit Hilfe des Median-Testes ermittelt das Zeituntersuchungsmodul 50 die Signifikanz dafür, dass die Zwischenzeit einen Einfluss auf die Ausbeute hat. Außerdem wird die Einflussstärke des Einflusses berechnet.

Die Untersuchungseinheit 30 führt außerdem weitere Median-Tests für Zeitabschnitte zwischen aufeinanderfolgenden Prozessstufen PS1, PS2, PS3, usw. durch. Nachdem die Ergebnisse für alle Median-Tests vorliegen, werden die Ergebnisse sortiert und der Rangfolge nach ausgegeben. Somit ist die Untersuchung bezüglich der Zeit zwischen aufeinanderfolgenden Prozessstufen PS1 bis PS201 lückenlos.

Bei einem anderen Ausführungsbeispiel wird ebenfalls eine lückenlose Untersuchung ausgeführt. Jedoch müssen nicht Zeiten zwischen unmittelbar aufeinanderfolgende Prozessstufen untersucht werden. Beispielsweise wird die Zeit zwischen den Prozessstufen PS1 und PS2, die Zeit zwischen den Prozessstufen PS2 und PS4, die Zeit zwischen den Prozessstufen PS5 und PS16, usw. untersucht.

Figur 4 zeigt drei Koordinatensysteme 150, 152 und 154, mit deren Hilfe das automatische Ermitteln der Ursache für eine periodische Schwankung der Ausbeute durch das Zeituntersuchungsmodul 50 erläutert werden soll. Die Abszissenachse 160 des Koordinatensystems 150 zeigt die Prozesszeit t, zu der die untersuchten Fertigungseinheiten prozessiert worden sind. Die Abszissenachsen 162 bzw. 164 der Koordinatensysteme 152 bzw. 154 zeigen Frequenzen f.

Die Ordinatenachse 166 des Koordinatensystems 150 dient zur Darstellung der Ausbeute YB der in der Prozessstufe PS1 bearbeiteten Fertigungseinheiten. Die Ausbeute YB sinkt ausgehend von einem Wert W1 zu einem Zeitpunkt t0 bis auf einen Wert W2 zu einem Zeitpunkt t1 ab, siehe Kurve 168. Zum Zeitpunkt t1 steigt die Ausbeute YB sprunghaft wieder auf den Wert W1 an.

Bis zu einem Zeitpunkt t2 fällt die Ausbeute dann wieder auf den Wert W2, siehe Kurve 170. Zum Zeitpunkt t2 steigt die Ausbeute sprunghaft auf den Wert W1 an. Danach kommt es bis zu einem Zeitpunkt t3 wieder zu einem Abfallen der Ausbeute bis auf den Wert W2, siehe Kurvenverlauf 172.

Im Koordinatensystem 152 ist das Ergebnis einer Fourier-Transformation der im Koordinatensystem 150 dargestellten Ausbeutewerte YB dargestellt. Eine Ordinatenachse 174 zeigt die Größe der Fourier-Koeffizienten. Bei der Fourier-Transformation wurden Frequenzkomponenten f0, f1, f2 und f3 erfasst. Die Frequenzkomponenten f2 und f3 sind Vielfache der Frequenzkomponente f1. Das Zeituntersuchungsmodul 50 ermittelt mit Hilfe eines vorgegebenen Schwellwertes SW, ob die bei der Fourier-Transformation für die Frequenzkomponenten f0 bis f3 ermittelten Koeffizienten den Schwellwert SW überschreiten. Ist dies der Fall, so wird ein Hinweis auf die betreffende Bearbeitungsstufe erzeugt, d.h. im Ausführungsbeispiel auf die Fertigungsstufe PS1.

Auf gleiche Weise führt das Zeituntersuchungsmodul 50 Fourier-Transformationen für die Funktionen der Ausbeute YB abhängig von der Prozesszeit bezogen auf die anderen Prozessstufen PS2 bis PS201 durch. Die Ergebnisse für die Prozessstufe PS2 sind im Koordinatensystem 154 dargestellt. Eine Ordinatenachse 180 dient zur Darstellung der Größe der bei der Fourier-Transformation ermittelten Koeffizienten. Die Koeffizienten für die Frequenzkomponenten f0, f1, f2 bzw. f3 sind für die Prozessstufe PS2 kleiner als die entsprechenden Komponenten der Frequenzkomponenten f0, f1, f2 bzw. f3 für die Prozessstufe PS1. Der Schwellwert SW wird durch keine der für die Prozessstufe PS2 berechneten Frequenzkomponenten erreicht.

Bei einem anderen Ausführungsbeispiel werden keine Schwellwerte SW verwendet. Jedoch berechnet das Zeituntersuchungsmodul 50 die Frequenzkomponenten für alle Prozessstufen PS1 bis PS201 bzw. für alle Prozessstufen, in denen periodische Vorgänge hervorgerufen werden können. Anschließend wird eine Rangfolge der Frequenzkomponenten aufgestellt, in der die Größe der Frequenzkomponenten ausgewertet wird. Die größten Werte für die Frequenzkomponenten werden in einer Rangliste ausgegeben. Zu jeder Frequenzkomponente wird die Frequenz f und die zugehörige Prozessstufe dargestellt.

Die Figuren 5A und 5B zeigen ein Ausführungsbeispiel für eine sogenannte ZOOM-Analyse zum Ermitteln einer Fertigungsschwäche mit Hilfe des ZOOM-Moduls 52.

In Figur 5A sind vier Koordinatensysteme 200 bis 206 dargestellt, deren Abszissenachse 210 bis 216 die Fertigungszeit t für die Prozessstufen PS4, PS5, PS6 bzw. PS7 zeigen. Ordinatenachsen 220 bis 226 der Koordinatensysteme 200 bis 206 zeigen die Größe eines Fertigungsfehlers F, der bei den betreffenden Fertigungseinheiten am fertigen Produkt ermittelt worden ist. Der die Prozessstufe PS4 betreffende Kurvenverlauf 230 steigt bis zu einem Maximum an, fällt dann bis auf ein lokales Minimum ab, steigt wieder bis auf ein lokales Maximum an und fällt dann wieder auf den Wert Null. Ein Kurvenverlauf 232 für den Fehler F bezüglich der Fertigungszeit t der Fertigungseinheiten in der Prozessstufe PS5 hat einen gaußglockenähnlichen Verlauf. Der Kurvenverlauf 232 ist sehr glatt, d.h. stärkere Schwankunge 5 treten nicht auf. Ein Kurvenverlauf 334 für den Fehler F bezogen auf die Fertigungszeit t in der Prozessstufe PS6 hat den Verlauf einer Gaußkurve mit zwei Nebenmaxima. Der Kurvenverlauf 234 hat starke Schwankungen. Ein Kurvenverlauf 236 für den Fehler F von Fertigungseinheiten, die bezüglich der Fertigungszeit t in der Prozessstufe PS7 geordnet sind, hat einen noch stärker zerklüfteten Verlauf.

Das ZOOM-Modul 52 ermittelt die Kurvenlänge der Kurvenverläufe 230 bis 236 und sucht den kürzesten Kurvenverlauf 232 aus. Es wird automatisch ein Hinweis auf die Prozessstufe PS5 mit dem kürzesten Kurvenverlauf ausgegeben, weil dort die Fehlerursache gesucht werden muss. Beispielsweise wurde im Maximum des Fehlers F eine Filtereinheit in der Prozessstufe PS5 ausgetauscht. Nach dem Austausch sank dann die Fehlerrate wieder kontinuierlich ab. Der Wartungszyklus für die Filtereinheit sollte also verkürzt werden.

Bei einem anderen Ausführungsbeispiel ermittelt das ZOOM-Modul 52 an Stelle der Kurvenlänge eine Näherung für die Kurvenlänge.

Figur 5B zeigt vier Koordinatensysteme 250, 252, 254 und 256, die in dieser Reihenfolge den Koordinatensystemen 200, 202, 204 bzw. 206 entsprechen. Gemäß der bereits oben erläuterten Formel:

$$m(op)=1/N \text{ Summe } |f(t+1)-f(t)| \text{ von } t=1 \text{ bis } N, \qquad (1)$$

wird für gleichlange Zeitintervalle berechnet, um welchen Betrag sich der Fehler F verändert. Die Beträge sind in dem Koordinatensystem 250 bis 256 durch vertikale Linien dargestellt, siehe beispielsweise Linien 258, 260 und 262. Anschließend addiert das ZOOM-Modul 52 die ermittelten Linienlängen auf. Es wird automatisch ein Hinweis auf die Prozessstufe PS5 ausgegeben, für die die kürzeste Summe der Linienlängen ermittelt worden ist.

Die an Hand der Figuren 5A und 5B gezeigten Kurvenverläufe 230 bis 236 sind die Folge davon, dass die Fertigungslose beim Durchlaufen des Fertigungssystems 10 ihre Reihenfolge ändern. Durch das lückenlose Erfassen der Kurvenverläufe für alle Prozessstufen PS1 bis PS201 oder für einen ausgewählten Fertigungsabschnitt PS4 bis PS7 lässt sich die Ursache für den Fehler F mit hoher Sicherheit und unter weitgehendem Ausschluss von Zufallselementen ermitteln.

Figur 6 zeigt eine Kontingenztafel 260 zum Ermitteln des Einflusses der für die Bearbeitung in der Prozessstufe PS1 ausgewählten Maschine M1 bis M3 auf die Ausbeute YB.

Die zur Bearbeitung eingesetzten Maschinen M1 bis M3 sind am linken Tafelrand 262 der Tafel 260 aufgeführt. Es wurde eine Grenze für die Ausbeute YB festgelegt, unterhalb der die Ausbeutewerte YB als schlecht eingestuft werden. Oberhalb der festgelegten Grenze wird die Ausbeute YB als gut eingestuft. Eine Spalte 264 zeigt die Anzahl der Fertigungseinheiten je Maschine M1 bis M3, die als schlecht eingestuft worden sind. Für die Maschinen M1, M2 und M3 wurden 20, 15 bzw. 25 Fertigungseinheiten als schlecht eingestuft. Die Summe der Fertigungseinheiten ergibt 60 und ist in der letzten Zeile der Spalte 264 dargestellt.

Für die Maschinen M1, M2 bzw. M3 wurden in dieser Reihenfolge 10, 45, 65 Fertigungseinheiten als gut eingestuft, siehe Spalte 266 der Tafel 260. Die Summe dieser Werte beträgt 120, siehe letzte Zeile der Spalte 266. Eine Spalte 268 der Tabelle 260 zeigt die Summen der Fertigungseinheiten, die als schlecht bzw. gut für die jeweilige Maschine M1, M2 und M3 eingestuft worden sind. Die Summen haben die Werte 30, 60 und 90. In der letzten Zeile der Spalte 268 ist der Wert der Gesamtsumme über die betrachteten Fertigungseinheiten eingetragen, nämlich 180. Mit Hilfe der Summenwerte lassen sich erwartete Werte für die Anzahl von Fertigungseinheiten in den einzelnen Feldern der Tafel 260 berechnen, falls die Fertigung auf den Maschinen M1, M2 und M3 unabhängig voneinander ist.

Beispielsweise lässt sich der erwartete Wert für die Maschine M1 und eine schlechte Ausbeute berechnen, indem die Gesamtzahl der mit der Maschine M1 gefertigten Fertigungseinheiten durch die Gesamtzahl der betrachteten Fertigungseinheiten dividiert wird. Zu diesem Zwischenergebnis wird die Gesamtzahl der als schlecht eingestuften Fertigungseinheiten dividiert durch die Gesamtzahl der Fertigungseinheiten multipliziert. Anschließend wird das zweite Zwischenergebnis noch mit der Gesamtzahl der betrachteten Fertigungseinheit multipliziert. Als Ergebnis erhält man den Wert 10, siehe Klammern 270.

Die beobachteten Werte werden als fi bezeichnet, wobei der Index i die Felder im mittleren Teil der Tafel 260 durchnumeriert. Die erwarteten Werte werden durch die Größe ei bezeichnet.

Gemäß den aus der Statistik bekannten Chi-Quadrat-Test wird die folgende Formel zum Berechnen der Größe Chi^2 verwendet:

$$Chi^2 = \Sigma\ (fi-ei)^2/ei \tag{2}$$

Die Anzahl der Freiheitsgrade Fhg wird durch Multiplikation der um eins verminderten Spaltenanzahl und der um eins verminderten Zeilenanzahl der Tafel 260 berechnet. Für die Tafel 260 ergibt sich der Freiheitsgrad 1. Mit Hilfe des Wertes Chi^2 und des Freiheitsgrades lässt sich unter Verwendung von Tabellen prüfen, ob eine der Maschinen M1 bis M3 bei einem vorgegebenen Signifikanzniveau, von beispielsweise 5% oder 1%, die Ausbeute YB stärker beeinflusst als die anderen Maschinen.

Bei einem anderen Ausführungsbeispiel führt das Maschinenvergleichsmodul 54 die Kontingenztafel-Analyse für alle Prozessstufen PS1 bis PS201 durch, in denen mehrere Maschinen für die Bearbeitung vorhanden sind. Die Testergebnisse werden anschließend abhängig von der Signifikanz und der Einflussstärke geordnet und auf einer Anzeigeeinheit dargestellt. Neben einer numerischen Datendarstellung wird auch eine grafische Darstellung unter Verwendung von Farben sichtbar.

Figur 7 zeigt alternative Prozessierungsstufen PS15a und PS15b. Mit Hilfe des Maschinenvergleichsmoduls 54 wird automatisch ermittelt, ob eine Prozessierungsschwäche vorliegt, d.h. ob die neu eingeführten Prozessierungsstufen PS15a und PS15b die Ausbeute YB signifikant beeinträchtigen. Ein Bearbeitungsweg WI verläuft von der Prozessstufe PS14 über die Prozessstufe PS15 zur Prozessstufe 16. Ein alternativer Bearbeitungsweg WII verläuft von der Prozessstufe PS14 über die Prozessstufe PS15a und die Prozessstufe PS15b zur Prozessstufe PS16.

In der Prozessstufe PS15 wird wahlweise eine von zwei Bearbeitungsmaschinen MA oder MB eingesetzt. In der Prozessstufe 15a wird wahlweise eine von zwei Bearbeitungsmaschinen MD oder ME eingesetzt. Es sei angenommen, dass die Untersuchung für 70 Fertigungseinheiten durchgeführt wird, von denen 30 Fertigungseinheiten den Bearbeitungsweg WI und 40 Bearbeitungseinheiten den Bearbeitungsweg WII durchlaufen haben.

Mit Hilfe der von den Maschinen MA bis ME gelieferten Daten und den Ausbeutewerten YB für die fertigen Produkte wurde ermittelt, dass die mittlere Ausbeute für die mit der Maschine MA gefertigten Fertigungseinheiten bei 71 % lag. Die mittlere Ausbeute YB für die mit der Maschine MB gefertigten Fertigungseinheiten lag bei 75 %. Die mittlere Ausbeute für die mit der Maschine MD gefertigten Fertigungseinheiten lag bei 50 %. Schließlich lag die mittlere Ausbeute YB für die mit der Maschine ME gefertigten Fertigungseinheiten bei 45 %. In die Untersuchung des Bearbeitungsweges WI wird auch die mittlere Ausbeute YB der über den Bearbeitungsweg WII geführten Fertigungseinheiten einbezogen. Die mittlere Ausbeute bei den über den Bearbeitungsweg WII geführten Fertigungseinheiten lag bei 47,5 %. Damit ergeben sich bei ähnlichen Tests, wie sie an Hand der Figur 6 erläutert worden sind, signifikante Unterschiede zwischen der Maschine MA bzw. MB und dem Bearbeitungsweg WII, der wie eine dritte Maschine der Prozessstufe PS15 behandelt wird.

Umgekehrt lässt sich der Bearbeitungsweg WI auch die Untersuchung der Maschinen MD und ME einbeziehen. In diesem Fall beträgt die mittlere Ausbeute YB der über den Bearbeitungsweg WI geführten Fertigungseinheiten 73 %.

Das Maschinenvergleichsmodul 54 sichert durch die automatische Einbeziehung aller Prozessstufen PS1 bis PS201 mit mehreren Bearbeitungsmaschinen bzw. mit mehreren Bearbeitungsalternativen, dass die Trefferquote bei der Fehlersuche nicht durch zufällige Elemente beeinflusst wird. Die Ergebnisse für die einzelnen Prozessstufen werden nämlich nach Signifikanz und Einflussstärke sortiert.

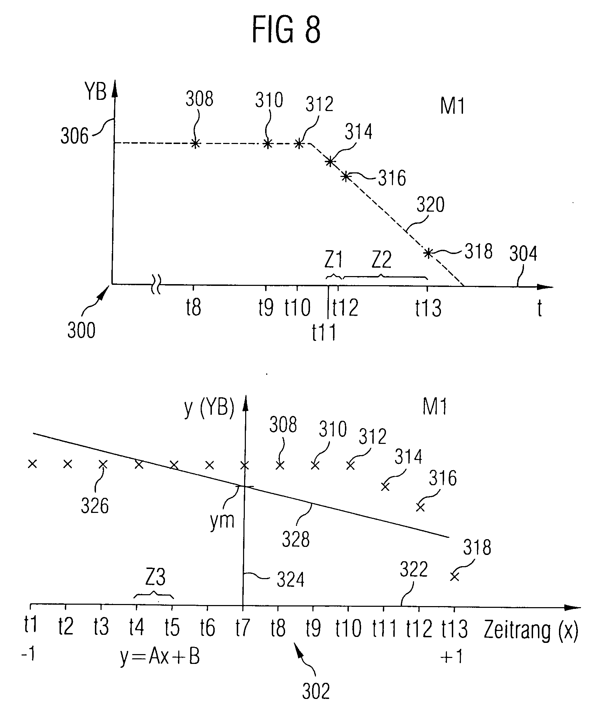

Figur 8 zeigt Koordinatensysteme 300 und 302, mit deren Hilfe eine durch das Maschinenvergleichsmodul 54 durchgeführte Maschinentrendanalyse erläutert werden soll. Eine Abszissenachse 304 des Koordinatensystems 300 dient zur Darstellung von Fertigungszeitpunkten t für Fertigungseinheiten, die mit der Maschine M1 gefertigt worden sind. Auf einer Ordinatenachse 306 des Koordinatensystems ist die Ausbeute YB abgetragen, die zu den Fertigungseinheiten gehört, die mit der Maschine M1 gefertigt worden sind. Kreuze 308 bis 318 betreffen in dieser Reihenfolge Fertigungseinheiten, die zu Zeitpunkten t8 bis t13 gefertigt worden sind. Zwischen aufeinanderfolgenden Zeitpunkten t8 bis t13 liegen unterschiedliche Zeitspannen, siehe die kurze Zeitspanne Z1 zwischen den Zeitpunkten t11 und t12 und die mehr als fünfmal so lange Zeitspanne Z2 zwischen den Zeitpunkten t12 und t13. Die Ausbeutewerte YB sind bis zum Zeitpunkt t10 etwa gleichbleibend hoch, siehe Kreuze 308, 310 und 312. Danach sinkt die Ausbeute kontinuierlich ab, siehe Kreuze 314 und 316 sowie 318. Ein gestrichelter Kurvenverlauf 320 approximiert den zeitlichen Verlauf der Ausbeute YB bezogen auf die mit der Maschine M1 gefertigten Fertigungseinheiten.

Eine Abszissenachse 322 des Koordinatensystems 302 dient zur Darstellung des Zeitranges der Zeitpunkte t1 bis t13 in einem skalierten Intervall von -1 bis +1. Auf einer Ordinatenachse 324 des Koordinatensystems 302 werden die Werte für die Ausbeute YB dargestellt. Die Ausbeute von den mit der Maschine M1 bearbeiteten Fertigungseinheiten ist wiederum durch Kreuze dargestellt, siehe Kreuze 308 bis 318. Weitere Kreuze zeigen die Ausbeute YB von Fertigungseinheiten, die vor dem Zeitpunkt t8 mit der Maschine M1 bearbeitet worden sind, siehe beispielsweise Kreuz 326. Die ursprünglich mit verschiedenen Abständen zu benachbarten Zeitpunkten liegenden Zeitpunkte t1 bis t13 wurden ihrer zeitlichen Reihenfolge nach geordnet und so verschoben, dass zwischen benachbarten Zeitpunkten gleiche Zeitintervalle Z3 liegen. Aufgrund der im Koordinatensystem 302 dargestellten Werte führt das Maschinenvergleichsmodul 54 automatisch eine lineare Regression aus und ermittelt eine Regressionsgerade 328, mit deren Hilfe der Verlauf der Kreuze 308 bis 318, sowie 326 approximiert wird.

Die Regressionsgerade 328 wird nach der folgenden Formel bestimmt:

$$y = Ax + B, \tag{3}$$

wobei A die Steigung und B den Schnittpunkt der Regressionsgeraden 328 angeben. Außerdem wird bei der Regressionsrechnung eine Signifikanz angegeben. Berechnet werden dann auch Angaben, mit deren Hilfe sich die Glaubwürdigkeit der Größen A und B abschätzen lässt.

Die Regressionsgerade 328 schneidet die y-Achse bei einem Wert ym, der dem mittleren Wert der Ausbeute YB der mit der Maschine M1 gefertigten Fertigungseinheiten entspricht. Der Anstieg der Regressionsgeraden 328 gibt den Maschinentrend wieder.

Bei einem anderen Ausführungsbeispiel ermittelt das Maschinenvergleichsmodul 545den Maschinentrend für alle im Prozesssystem 10 vorhandenen Maschinen M1 bis M11. Aufgrund der Skalierung lassen sich die Maschinentrends untereinander vergleichen. Durch Sortieren der für die einzelnen Regressionsgeraden berechneten Anstiege lassen sich auf einfache Art die Maschinen ermitteln, deren Bearbeitungsqualität besonders schnell im Vergleich zu den anderen Maschinen sinkt. Solche Maschinen sind die Ursache für starke Verringerungen der Ausbeute YB. Außerdem lassen sich die Mittelwerte ym der einzelnen Maschinen mit den Mittelwerten der Ausbeute YB über alle Maschinen vergleichen.

Bei anderen Ausführungsbeispielen werden die durch die Untersuchungseinheit 30 ermittelten Ergebnisse daraufhin überprüft, ob besonders kritische Situationen vorliegen können. Ist dies der Fall, so wird automatisch die Bearbeitungsmaschine gestoppt, die für die Fehlerursache in Frage kommt. Alternativ oder kumulativ lassen sich jedoch auch alle Maschinen einer Prozessstufe automatisch ausschalten.

Bei einem weiteren Ausführungsbeispiel enthält die Untersuchungseinheit 30, siehe Figur 2, auch ein Prozessparametervergleichsmodul, mit dessen Hilfe Prozessparameter untersucht werden. Beispielsweise wird die Ätzzeit in kurze, mittlere und lange Ätzzeiten unterteilt. Anschließend werden beispielsweise die Ausbeuten der mit den jeweiligen Ätzzeiten (kurz, mittel, lang) geätzten Fertigungseinheiten auf die gleiche Weise untersucht, wie oben an Hand der Figur 6 für verschiedene Maschinen erläutert.

**Patentansprüche**

1. Verfahren zum Ermitteln von Fertigungs- und/oder Prozessierungsschwachen,
   bei dem Fertigungseinheiten (12) eine Vielzahl von Bearbeitungsstufen (PS1 bis PS 201) durchlaufen,
   bei dem auf Fertigungseinheiten (12) bezogene Werte für eine Gütegröße (YB) zur Bewertung der Fertigung ermittelt werden,
   bei dem eine Untersuchungsgröße (M1 bis M3) vorgegeben wird, deren Auswirkung auf die Gütegröße (YB) zu untersuchen ist,
   bei dem mit Hilfe von für die Untersuchungsgröße (M1 bis M3) ermittelten Werten geprüft wird, ob die Untersuchungsgröße (M1 bis M3) einen signifikanten Einfluss und/oder eine besondere Einflussstärke auf die Gütegröße (YB) hat, die eine vorgegebene Mindesteinflussstärke überschreitet,
   **dadurch gekennzeichnet, dass** für mindestens zwei Bearbeitungsstufen (PS1, PS2) und/oder für mindestens zwei Bearbeitungsabschnitte aus jeweils aufeinanderfolgenden Bearbeitungsstufen automatisch die Signifikanz und/oder die Einflussstärke ermittelt wird,
   und dass automatisch abhängig von der Einflussstärke der Untersuchungsgröße (M1 bis M3) und/oder der Signifikanz des Einflusses der Untersuchungsgröße (M1 bis M3) auf die Gütegröße (YB) je Bearbeitungsstufe (PS1, PS2) mindestens eine Bearbeitungsstufe (PS1) und/oder ein Bearbeitungsabschnitt ausgewählt wird, in dem die Ursache für eine Fertigungsund/oder Prozessierungsschwäche zu suchen ist.

2. Verfahren nach Anspruch 1, **dadurch gekennzeichnet, dass** nur solche Bearbeitungsstufen (PS1, PS2) und/oder Bearbeitungsabschnitte in das Ermitteln der Signifikanz und/oder der Einflussstärke einbezogen werden, in denen die Untersuchungsgröße (M1 bis M3) mehrere Ausprägungen hat.

3. Verfahren nach Anspruch 1 oder 2, **dadurch gekennzeichnet, dass** innerhalb eines Fertigungsabschnitts (PS4 bis PS7) oder innerhalb der gesamten Fertigung (PS1 bis PS201) der überwiegende Teil der Bearbeitungsstufen (PS1, PS2) und/oder der Bearbeitungsabschnitte untersucht werden, unabhängig davon, ob ein Einfluss der Untersuchungsgröße (M1 bis M3) auf die Gütegröße (YB) erwartet wird, oder abhängig davon, ob ein Einfluss der Untersuchungsgröße (M1 bis M3) auf die Gütegröße (YB) erwartet wird.

4. Verfahren nach Anspruch 1 oder 2, **dadurch gekennzeichnet, dass** innerhalb eines Fertigungsabschnitts (PS4 bis PS7) oder innerhalb der gesamten Fertigung (PS1 bis PS201) alle Bearbeitungsstufen (PS1, PS2) und/oder lückenlos aufeinanderfolgende Bearbeitungsabschnitte untersucht werden, unabhängig davon, ob ein Einfluss der Untersuchungsgröße (M1 bis M3) auf die Gütegröße (YB) erwartet wird, oder abhängig davon, ob ein Einfluss der Untersuchungsgröße (M1 bis M3) auf die Gütegröße (YB) erwartet wird.

5. Verfahren nach einem der vorhergehenden Ansprüche, **dadurch gekennzeichnet, dass** zur Feststellung der Signifikanz und/oder der Einflussstärke ein nichtparametrischer Test eingesetzt wird.

6. Verfahren nach einem der Ansprüche 1 bis 4, **dadurch gekennzeichnet, dass** zur Feststellung der Signifikanz und/oder der Einflussstärke ein parametrischer Test eingesetzt wird,
und/oder dass aus den Werten für die Untersuchungsgröße (M1 bis M3) vor Ausführung des Tests Ausreißer entfernt werden.

7. Verfahren nach Anspruch 5 oder 6, **dadurch gekennzeichnet, dass** die Verteilung der Werte der Untersuchungsgröße (M1 bis M3) unter Berücksichtigung einer Rangfolge dieser Werte jedoch unter Beibehaltung der Monotonie geändert wird.

8. Verfahren nach einem der vorhergehenden Ansprüche, **dadurch gekennzeichnet, dass** beim Test zum Ermitteln der Signifikanz eine Bonferroni-Korrektur durchgeführt wird.

9. Verfahren nach einem der vorhergehenden Ansprüche, **dadurch gekennzeichnet, dass** die Werte der Untersuchungsgröße (M1 bis M3) Fertigungseinheiten (12) zur Herstellung von Produkten verschiedener Produktarten betreffen,
oder dass die Werte der Untersuchungsgröße (M1 bis M3) nur Fertigungseinheiten (12) zur Herstellung einer Produktart betreffen.

10. Verfahren nach einem der vorhergehenden Ansprüche, **dadurch gekennzeichnet, dass** die Untersuchungsgröße einen Zeitpunkt, einen Zeitabschnitt, eine Zeitdifferenz oder eine Zeitperiode betrifft.

11. Verfahren nach Anspruch 10, **dadurch gekennzeichnet, dass** die Untersuchungsgröße die Zeitdifferenz zwischen vorgegebenen Bearbeitungsstufen (PS1, PS2) oder Bearbeitungsabschnitten betrifft.

12. Verfahren nach Anspruch 10 oder 11, **dadurch gekennzeichnet, dass** ein Median-Test oder ein Kruskal-Wallis-Test zum Ermitteln der Signifikanz und/oder der Einflussstärke eingesetzt wird.

13. Verfahren nach einem der Ansprüche 10 bis 12, **dadurch gekennzeichnet, dass** die Untersuchungsgröße die zeitliche Periode von Schwankungen (168 bis 172) der Gütegröße (YB) betrifft.

14. Verfahren nach Anspruch 13, **dadurch gekennzeichnet, dass** je untersuchter Bearbeitungsstufe (PS1, PS2) die Fertigungseinheiten (12) gemäß der Bearbeitungsreihenfolge geordnet werden,
dass eine Transformation der Gütegröße aus dem Zeitbereich in den Frequenzbereich ausgeführt wird,
und dass abhängig von den transformierten Werten eine Bearbeitungsstufe (PS1) ausgewählt wird.

15. Verfahren nach einem der Ansprüche 1 bis 9, **dadurch gekennzeichnet, dass** die Untersuchungsgröße der Verlauf (230 bis 236) der Gütegröße (YB) abhängig von der Reihenfolge der Bearbeitung der Fertigungseinheiten (12) je Bearbeitungsstufe (PS4 bis PS7) ist.

**16.** Verfahren nach Anspruch 15, **dadurch gekennzeichnet, dass** die Glattheit des Verlaufs (230 bis 236) die Untersuchungsgröße ist.

**17.** Verfahren nach Anspruch 16, **dadurch gekennzeichnet, dass** die Kurvenlänge des Verlaufs (230 bis 236) der Gütegröße (YB) je Bearbeitungsstufe (PS4 bis PS7) als Maß für die Glattheit dient oder dass eine Näherung für die Kurvenlänge des Verlaufs (230 bis 236) als Maß für die Glattheit dient.

**18.** Verfahren nach Anspruch 17, **dadurch gekennzeichnet, dass** die Näherung nach der folgenden Formel berechnet wird:

$$m(op)=1/N \text{ Summe } |f(t+1)-f(t)| \text{ von } t=1 \text{ bis } N,$$

wobei m(op) die genäherte Länge des Verlaufs (230 bis 236), t die Position in der Reihenfolge, f(t) die Gütegröße der Fertigungseinheit an der Position t, op die Bearbeitungsstufe oder den Bearbeitungsabschnitt und N die Gesamtzahl der betrachteten Fertigungseinheiten bezeichnen.

**19.** Verfahren nach einem der Ansprüche 1 bis 9, **dadurch gekennzeichnet, dass** die Untersuchungsgröße die Abhängigkeit der Gütegröße (YB) von der zur Bearbeitung der Fertigungseinheiten ausgewählten Bearbeitungsmaschine (M1 bis M3) aus einer Gruppe mehrerer Bearbeitungsmaschinen (M1 bis M3) zur Ausführung der gleichen Bearbeitungsstufe (PS1) ist,
und/oder dass die Untersuchungsgröße ein Prozessparameter ist.

**20.** Verfahren nach Anspruch 19, **dadurch gekennzeichnet, dass** als Test eine Kontingenztafel-Analyse (260) oder ein Kruskal-Wallis-Test eingesetzt wird.

**21.** Verfahren nach Anspruch 19 oder 20, **dadurch gekennzeichnet, dass** mindestens ein alternativer Prozessierungszweig (WI bis WII) wie eine zusätzliche Maschine und/oder wie eine zusätzliche Prozessparametergruppe in den Test einbezogen werden.

**22.** Verfahren nach einem der vorhergehenden Ansprüche, **dadurch gekennzeichnet, dass** als Untersuchungsgröße eine Maschine (M1 bis M3) ausgewählt wird.

**23.** Verfahren nach Anspruch 22, **dadurch gekennzeichnet, dass** eine Skalierung auf ein vorgegebenes Intervall ausgeführt wird,
und/oder dass eine Zentrierung ausgeführt wird,
und/oder dass eine zeitliche Rangfolge der Werte der Gütegröße (YB) berücksichtigt wird.

**24.** Verfahren nach Anspruch 23, **dadurch gekennzeichnet, dass** eine Regressionsrechnung oder eine lineare Regressionsrechnung (328) zum Bestimmen des Maschinentrends ausgeführt wird.

**25.** Verfahren zum Ermitteln von Maschinentrends,
bei dem automatisch für mit einer Maschine (M1) bearbeitete Fertigungseinheiten (12) Werte einer Gütegröße (YB) ermittelt werden,
**dadurch gekennzeichnet, dass** die Werte der Gütegröße (YB) in eine Reihenfolge gebracht werden, in der die zu den Werten gehörenden Fertigungseinheiten (12) auf der Maschine bearbeitet worden sind,
dass die Werte der Gütegröße (YB) bezüglich der Zeit abhängig von ihrem Rang in der Reihenfolge auf gleiche Zeitabstände zwischen benachbarten Werten versetzt werden,
und dass ausgehend von den versetzten Werten eine Regressionsrechnung (328) zum Bestimmen des Maschinentrends ausgeführt wird.

**26.** Verfahren nach Anspruch 25, **dadurch gekennzeichnet, dass** vor der Regressionsrechnung eine Skalierung der werte auf ein vorgegebenes Zeitintervall ausgeführt wird oder dass eine Skalierung auf ein für alle Maschinen eines Fertigungssystems (10) gleiches Zeitintervall ausgeführt wird.

**27.** Verfahren nach Anspruch 25 oder 26, **dadurch gekennzeichnet, dass** vor der Regressionsrechnung (328) eine Zentrierung der Werte bezüglich der Zeit um den Wert Null herum ausgeführt wird.

**28.** Verfahren nach einem der vorhergehenden Ansprüche, **dadurch gekennzeichnet, dass** die Fertigung die Herstellung von integrierten Schaltkreisen betrifft.

**29.** Verfahren nach einem der vorhergehenden Ansprüche, **dadurch gekennzeichnet, dass** sämtliche Verfahrensschritte automatisch ausgeführt werden.

**30.** Programm mit einer Befehlsfolge, bei deren Ausführung durch einen Prozessor ein Verfahren nach einem der vorhergehenden Ansprüche ausgeführt wird.

**31.** Datenverarbeitungsanlage, **dadurch gekennzeichnet, dass** die Datenverarbeitungsanlage (30) ein Programm nach Anspruch 30 enthält.

**32.** Fertigungssystem (10), **dadurch gekennzeichnet, dass** das Fertigungssystem (10) so aufgebaut ist, dass bei seinem Betrieb ein Verfahren nach einem der Ansprüche 1 bis 29 ausgeführt wird.

EP 1 235 270 A2

FIG 1

automatische Ermittlung von Produktionsschwächen

# FIG 2

30

Zeituntersuchungsmodul — 50

ZOOM-Modul — 52

Maschinenvergleichsmodul — 54

# FIG 3

Median-Test

YB

106

108

104

112

102

100

110

dt(op_2, op_1)[Tagen]

| Median-Test | YB-gut | YB-schlecht | |
|---|---|---|---|
| $dt \leq$ Median(dt) | 20 | 10 | — 120 |
| $dt \geq$ Median(dt) | 10 | 20 | — 122 |

114

116

118

# FIG 4

# FIG 5A

PS4 — Fehler vs t_op_4 (220, 230, 210, 200)
PS5 — Fehler vs t_op_5 (222, 232, 212, 202)
PS5 — Fehler vs t_op_6 (224, 234, 214, 204)
PS7 — Fehler vs t_op_7 (226, 236, 216, 206)

# FIG 5B

PS4 — Fehler vs t_op_4 (250, 258)
PS5 — Fehler vs t_op_5 (252, 260)
PS6 — Fehler vs t_op_6 (254)
PS7 — Fehler vs t_op_7 (256, 262)

EP 1 235 270 A2

## FIG 6

Kontingenztafel-Analyse

| beobachtet fi (erwartet) ei | YB_schlecht | YB_gut | Σ |
|---|---|---|---|
| M1 | 20(10) | 10(20) | 30 |
| M2 | 15(20) | 45(40) | 60 |
| M3 | 25(30) | 65(60) | 90 |
| Σ | 60 | 120 | 180 |

270

262    264    266    268

260

$$\chi 2 = \sum_i \frac{(fi-ei)^2}{ei}$$

Fhg = (Anzahl Spalten-1) x (Anzahl Zeilen-1) = 1

## FIG 7

WI

PS14

30

MA

PS15

MB

PS16

70

YB

WI  MA 71%
    MB 75%
    WII 47,5%

PS15a

40

MD

WII

ME

PS15b

WII MD 50%
    ME 45%
    WI 73%

# FIG 8